# EUROPEAN PATENT APPLICATION

(11) **EP 4 056 290 A1**
(43) Date of publication of application: **14.09.2022**
(21) Application number: 20885443.0
(22) Date of filing: 22.10.2020
(51) Int. Cl.: B09B 3/00, B09B 5/00

(54) **SEPARATION METHOD FOR LAYERED STRUCTURE**

(30) Priority: 06.11.2019 JP 2019201487
(71) Applicant: Solar Frontier K.K., Tokyo 100-0005 (JP)
(72) Inventor: HARADA Hideki, Tokyo 100-0005 (JP)
(74) Representative: Hoffmann Eitle
(86) International application number: PCT/JP2020/039781
(87) International publication number: WO 2021/090695

(57) **Abstract**

A method for separating a laminate structure in which a resin layer is formed on a substrate includes applying a shear load to the laminate structure from a direction intersecting a lamination direction of the resin layer; and pulverizing the substrate, and the resin layer is separated from the substrate at an interface between the substrate and the resin layer.

## Description

### Technical Field

The present invention relates to a method for separating a laminate structure in which a resin layer is formed on a substrate.

### Background Art

In recent years, from the viewpoint of resource utilization and environmental protection, how to efficiently recycle, for example, used solar cell modules as resources has been a problem.

For the solar cell module, various materials such as a solar cell element that realizes photoelectric conversion, a glass plate that protects the solar cell element, and a filler that bonds each member are used. In order to recycle these materials, it is required to separate each member.

For example, Patent Literature 1 discloses a recycling device for a solar cell module that peels off a glass substrate from another material. In Patent Literature 1, a blade is brought into contact with a position between a glass substrate and another material layer (sealing material) of a conveyed solar cell module to peel off the glass substrate from the other material.

Patent Literature 2 discloses a glass separation device that separates glass from a processed product obtained by attaching a sheet containing resin to plate-shaped glass. In Patent Literature 2, the processed product is nipped between crushing rollers and conveyed, so that the glass of the processed product is crushed, and the crushed glass pieces are conveyed while being attached to the sheet. Thereafter, the sheet is nipped between a scraping roller and a pressing roller, and the glass pieces attached to the sheet of the processed product are scraped off by the scraping roller.

### Citation List

### Patent Literature

Patent Literature 1: JP 2016-203061 A
Patent Literature 2: JP 2016-203128 A

### Summary of Invention

### Technical Problem

However, as for a laminate structure in which a resin layer such as a sealing material is formed on a substrate such as a glass substrate like a solar cell module, adhesion between the substrate and the resin layer is high, and it is difficult to efficiently separate the substrate and the resin layer. If the purity of each material after separation is low, recycling of each material will be hindered.

In addition, the techniques of Patent Literatures 1 and 2 are not suitable for, for example, processing a laminate structure (for example, those that become small or come to have an irregular shape due to breakage) that is difficult to convey, or efficiently processing many small laminate structures. Moreover, in the techniques of Patent Literatures 1 and 2, since a solar cell module is conveyed and processed, the equipment is increased in size.

The present invention has been made in view of the above circumstances, and an object thereof is to provide a separation method capable of efficiently separating a resin layer from a substrate of a laminate structure.

### Solution to Problem

A method for separating a laminate structure serving as an aspect of the present invention is a method for separating a laminate structure in which a resin layer is formed on a substrate includes applying a shear load to the laminate structure from a direction intersecting a lamination direction of the resin layer; and pulverizing the substrate, and the resin layer is separated from the substrate at an interface between the substrate and the resin layer.

### Advantageous Effects of Invention

According to the present invention, a resin layer can be efficiently separated from a substrate of a laminate structure.

### Brief Description of Drawings

Fig. 1 is a diagram illustrating a configuration example of a thin-film solar cell module.
Fig. 2 is a diagram illustrating a configuration example of a crystalline solar cell module.
Fig. 3 is a flowchart for describing a method for recycling a solar cell module.
Fig. 4 is a diagram illustrating an example of separation of a cover glass by a separator.
Fig. 5 is a perspective view illustrating an outline of a mortar-shaped separation device.
Fig. 6 is a schematic diagram illustrating processing steps by a mortar-shaped separation device.
Fig. 7 is a diagram for describing a force acting on a workpiece in a mortar-shaped separation device.
Fig. 8(a) illustrates a mixture discharged from a separation device in Example 1, and Fig. 8(b) illustrates supernatants and sediments when the mixture was immersed in a dissolving liquid in Example 1.
Fig. 9(a) illustrates a first separated product separated in Example 1, Fig. 9(b) illustrates a second separated product separated in Example 1, and Fig. 9(c) illustrates a third separated product separated in Example 1.

### Description of Embodiments

Hereinafter, embodiments will be described with reference to drawings.

In the embodiment, for the sake of more understandable description, structures or elements other than the main parts of the present invention will be described in a simplified or omitted manner. In addition, in the drawings, the same elements are denoted by the same reference signs. To be noted, in the drawings, shapes, dimensions, and the like of each element are schematically illustrated, and do not indicate actual shapes, dimensions, and the like.

In the present embodiment, a method for separating a laminate structure in which a resin layer is formed on a substrate will be described by taking a solar cell module as an example. First, a configuration example of the solar cell module will be described.

### <Configuration Example of Solar Cell Module>

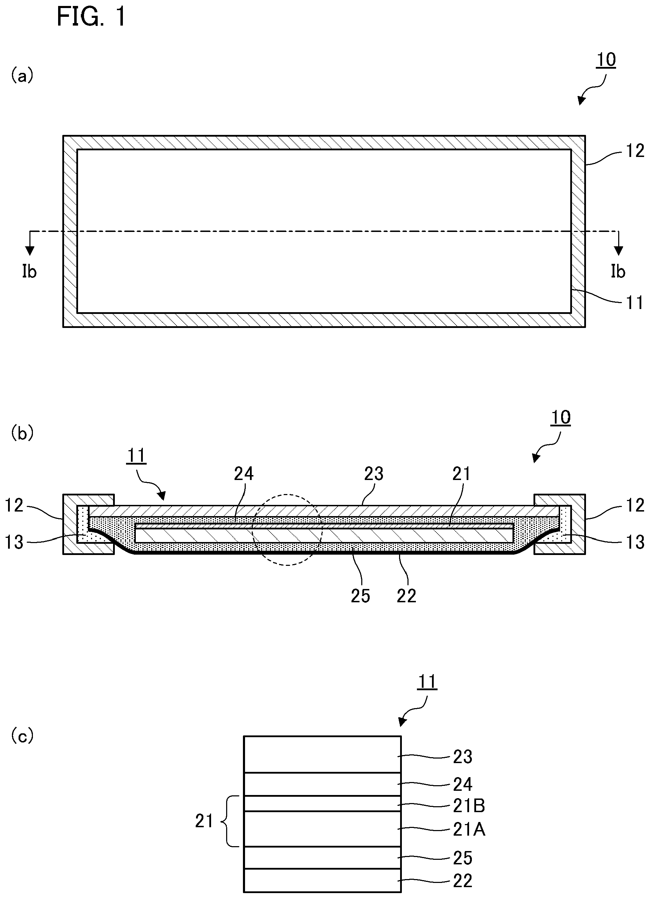

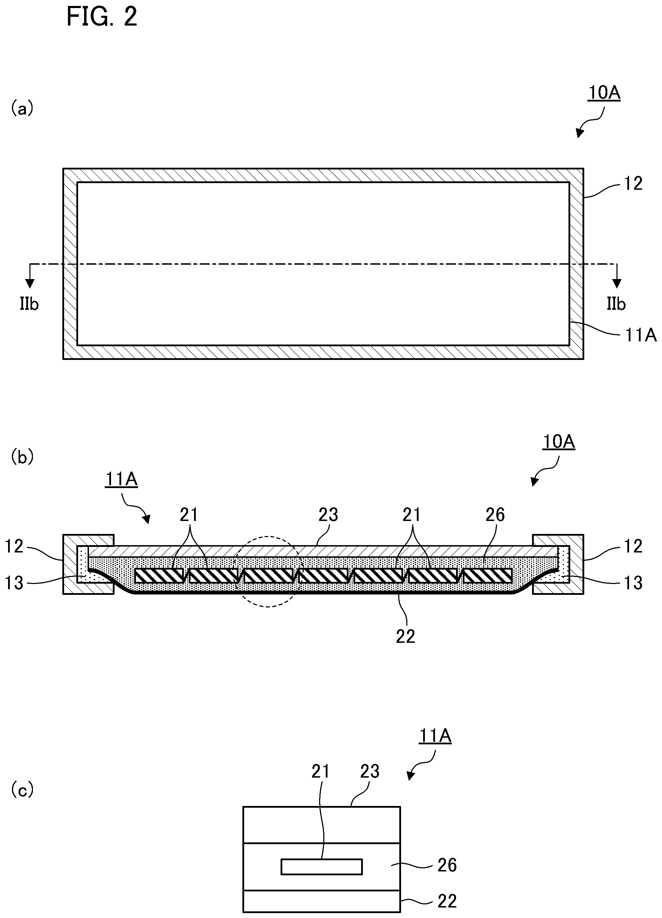

The type of the solar cell module that can be recycled in the present embodiment is not particularly limited. In the present embodiment, two solar cell modules will be described: a thin-film solar cell module as a first example illustrated in Figs. 1(a) to 1(c); and a crystalline solar cell module as a second example illustrated in Figs. 2(a) to 2(c). Note that the thin-film solar cell module is characterized in that the thin-film solar cell module can be more easily thinned and the cost thereof can be more easily reduced than the crystalline solar cell module.

Fig. 1(a) is a plan view of the solar cell module (thin-film solar cell module) of the first example, and Fig. 1(b) is a section view taken along a line Ib-Ib of Fig. 1(a). Fig. 1(c) is a diagram schematically illustrating a structure of a part circled by a broken line in Fig. 1(b).

As illustrated in Fig. 1(a), a solar cell module 10 of the first example has a rectangular solar cell panel 11 and a frame 12 disposed so as to surround the outer edge of the solar cell panel 11 in the circumferential direction. Note that a terminal box and an output cable (both not illustrated) serving as a power outlet are attached to the back surface of the solar cell module 10.

As illustrated in Fig. 1(b), a space between the solar cell panel 11 and the frame 12 is sealed by a sealing material 13. The sealing material 13 may be, for example, a material similar to or different from a material of a sealing layer that will be described later.

As illustrated in Fig. 1(c), the solar cell panel 11 includes an electric cell portion 21, a back sheet 22, a cover glass 23, a first sealing layer 24, and a second sealing layer 25. The cover glass 23 is, for example, a white plate reinforced glass, a transparent resin plate, or the like.

In addition, the first sealing layer 24 is disposed between the electric cell portion 21 and the cover glass 23. The first sealing layer 24 seals the surface side of the electric cell portion 21 by pressurization and heating, and brings an electric cell layer 21B that will be described later and the cover glass 23 into close contact with each other. Examples of the sealing material constituting the first sealing layer 24 include a polyethylene-based resin, a fluorine-based resin, a polystyrene-based resin, a polyolefin-based resin, a silicone resin, and a butyl rubber. Although not particularly limited, the thickness of the first sealing layer 24 is about 200 µm to 1000 µm.

The electric cell portion 21 is an example of a substrate, and includes a substrate glass 21A and an electric cell layer 21B formed on the surface side of the substrate glass 21A. That is, the solar cell panel 11 has a structure in which the electric cell layer 21B is sandwiched between two glass plates (the cover glass 23 and the substrate glass 21A).

However, the substrate glass 21A can be changed to a resin substrate, a metal substrate, a flexible substrate (for example, a flexible substrate having a laminate structure of stainless steel (SUS), aluminum, and aluminum oxide) having flexibility, or the like. Further, the substrate glass 21A may contain an alkali metal such as sodium or potassium.

Although not particularly limited, the thickness of the substrate is about 1.0 mm to about 4.0 mm in the case of a glass substrate, and about 100 µm to about 500 µm in the case of other substrates.

The electric cell layer 21B is a semiconductor element having a photoelectric conversion function of converting light into electricity. Light incident on the electric cell layer 21B is incident on the electric cell layer 21B from the cover glass 23 side.

The electric cell layer 21B has, for example, a laminate structure in which a photoelectric conversion layer is disposed between a metal electrode layer of a transition metal or the like and a transparent electrode layer of a metal oxide or the like. The photoelectric conversion layer described above includes, for example, a compound thin film of group I-III-VI₂, group I₂-II-IV-VI₄, group II-VI, or the like, an organic semiconductor, a perovskite crystal, or the like.

The back sheet 22 is an example of a sheet body, and is a protective sheet that covers the back surface side of the substrate glass 21A. The back sheet 22 is attached so as to face the second sealing layer 25.

The back sheet 22 is formed by, for example, coating a surface of a polyethylene terephthalate resin, a polyester-based resin, a fluorine-based resin, a polystyrene-based resin, or a resin film with various vapor deposition layers. Although not particularly limited, the thickness of the back sheet 22 is about 100 µm to about 700 µm.

The second sealing layer 25 is disposed between the substrate glass 21A and the back sheet 22. The second sealing layer 25 seals the back surface side of the electric cell portion 21 by pressurization and heating, and brings the back surface of the substrate glass 21A and the back sheet 22 into close contact with each other. To be noted, the thickness and material of the second sealing layer 25 are the same as those of the first sealing layer 24.

Fig. 2(a) is a plan view of the solar cell module (crystalline solar cell module) of the second example, and Fig. 2(b) is a section view taken along a line IIb-IIb of Fig. 2(a). Fig. 2(c) is a diagram schematically illustrating a structure of a part circled by a broken line in Fig. 2(b).

Note that, in the description regarding Fig. 2, the same reference signs are given to portions that overlap with those in Fig. 1, and redundant description is omitted.

As illustrated in Fig. 2(a), a solar cell module 10A of the second example includes a rectangular solar cell panel 11A and a frame 12 disposed so as to surround the outer edge of the solar cell panel 11A in the circumferential direction. Note that a terminal box and an output cable (both not illustrated) serving as a power outlet are attached to the back surface of the solar cell module 10A.

As illustrated in Fig. 2(b), a space between the solar cell panel 11A and the frame 12 is sealed by a sealing material 13.

As illustrated in Fig. 2(c), the solar cell panel 11A includes a back sheet 22, a cover glass 23, a sealing layer 26 formed of a sealing material, and a plurality of electric cell portions 21 made of silicon substrates. Although not particularly limited, the thickness of the silicon substrate is about 100 µm to about 500 µm.

The plurality of electric cell portions 21 are connected in series to form a so-called cell string.

These electric cell portions 21 are disposed between the back sheet 22 and the cover glass 23, and are covered and sealed with the sealing layer 26. The sealing layer 26 has a function of bringing the electric cell portions 21 into close contact with the back sheet 22 or the cover glass 23. The other points are similar to those of the first example.

Here, as for the adhesive force for each layer in the solar cell panel, the adhesive force at the interface between the back surface side of the substrate on which the electric cell layer is not formed and the sealing layer is the largest.

In addition, when the materials of the layers of the solar cell panel are arranged in order of ease of shear deformation, the sealing material of the sealing layer, the back sheet, and the substrate are arranged in this order. To be noted, in the material of each layer of the solar cell panel, the substrate is more brittle than resin (sealing material of sealing layer, back sheet).

### <Method for Recycling Solar Cell Module>

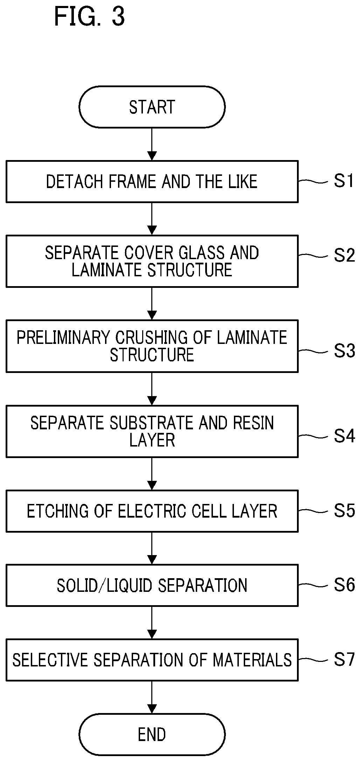

Next, a method for recycling a solar cell module will be described with reference to Fig. 3. In the following description, for the sake of simplicity, the solar cell module is based on the configuration of Fig. 1 unless otherwise specified.

### (Step S1: Removal of frame or the like)

First, the frame 12 and the terminal box are removed from the solar cell module 10 to be recycled, and the solar cell panel 11 is taken out.

### (Step S2: Separation of cover glass and laminate structure)

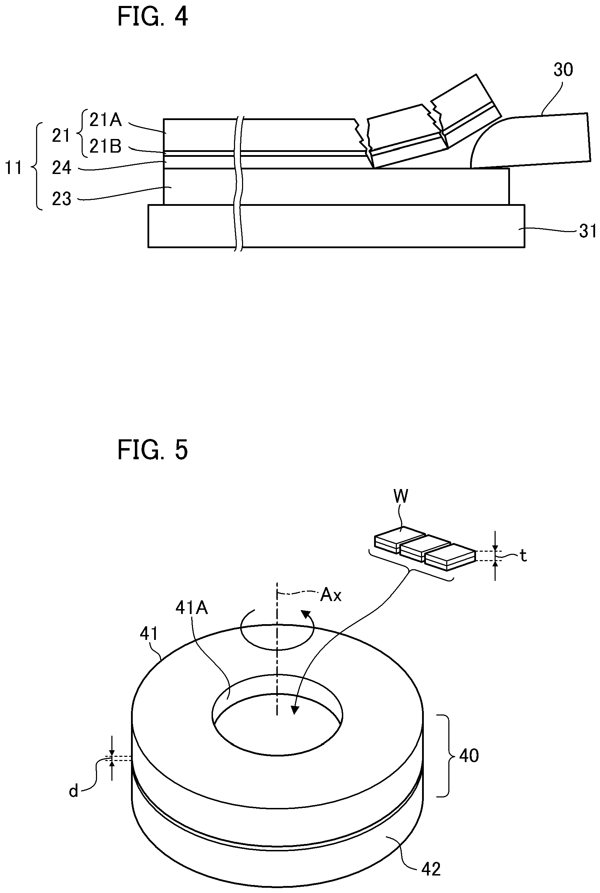

Next, as illustrated in Fig. 4, the solar cell panel 11 is placed on a stage 31, and a separator 30 is pressed against a side surface of the solar cell panel 11. As a result, the substrate portion including the electric cell portion 21 of the solar cell panel 11 is peeled off from the cover glass 23 by the separator 30, and the cover glass 23 is separated from the solar cell panel 11. The separated cover glass 23 can be recycled as a glass cullet raw material.

By removing the cover glass 23 from the solar cell panel 11 in step S2, a laminate structure in which a resin layer (for example, a sealing layer of a sealing material or a back sheet) is formed on the substrate 21 can be obtained.

Here, the laminate structure is, for example, a laminate of sealing layer/glass substrate/sealing layer/back sheet in the case of the thin film solar cell panel 11 illustrated in Fig. 1, and a laminate of sealing layer/silicon substrate/sealing layer/back sheet in the case of the crystalline solar cell panel 11A illustrated in Fig. 2. Note that the configuration of the laminate structure may be, for example, a laminate in which a substrate and a resin layer are laminated, such as a substrate/sealing layer, other than the above.

To be noted, in step S2, the back sheet 22 may be further separated from a portion other than the cover glass 23 by a separator. In this case, the back sheet 22 can be recycled in still a sheet-shaped state. In the separation of the back sheet 22, the separator 30 used for separating the cover glass 23 can be used as it is.

### (Step S3: Preliminary crushing of laminate structure)

Next, the laminate structure separated from the cover glass 23 is crushed by a crusher. The crushing in step S3 is performed to make the laminate structure a desired size suitable for the processing in step S4 that will be described later.

Examples of the crusher used in step S3 include a uniaxial crusher that continuously performs crushing to a desired size or less with a single blade, a biaxial crusher that performs crushing in one-through while biting the substrate with blades facing each other, and a vertical crusher that continuously performs crushing to a desired size or less by hitting with a high-speed rotating hammer.

The laminate structure after the crushing in step S3 has a size of, for example, about 1 mm to several tens of mm (preferably about 1 mm to 20 mm) according to the particle size of the final pulverized product. The laminate structure after the crushing in step S3 will be hereinafter also referred to as a workpiece W.

In addition, at the stage of the crushing in step S3, the remaining laminate structure separated from the cover glass 23 is crushed and partially peeled off. In the case of the uniaxial crusher and the vertical crusher, the peeling can occur at an interface between the back surface of the substrate including the electric cell layer and the sealing layer, an interface between the sealing layer and the back sheet, and an interface between the sealing layer and the electric cell layer (the outermost surface of the electric cell layer is a transparent conductive film). In the case of a biaxial crusher, peeling can occur at the interface between the sealing layer and the electric cell layer (the outermost surface of the electric cell layer is a transparent conductive film).

### (Step S4: Separation of substrate and resin layer)

Next, the resin layer is separated from the substrate 21 of the workpiece W, and the components of the workpiece W are pulverized to further reduce the size using a mortar-shaped separation device 40.

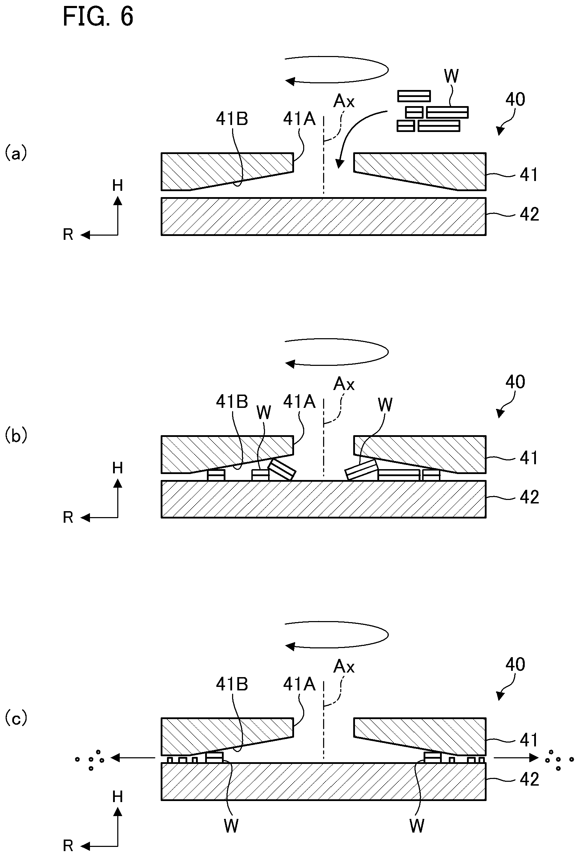

Fig. 5 is a perspective view illustrating an outline of the mortar-shaped separation device 40 used in step S4, and Fig. 6 is a schematic diagram illustrating a processing step by the mortar-shaped separation device 40.

In the mortar-shaped separation device 40, an upper plate 41 made of an annular grindstone having an introduction port 41A at the center and a lower plate 42 made of a disk-shaped grindstone are arranged to face each other, and at least one of the upper plate 41 and the lower plate 42 is configured to be rotatable. A lower surface 41B of the upper plate 41 facing the lower plate 42 forms a tapered surface inclined upward from the outer peripheral side toward the inner peripheral side. A distance d between the outer peripheral portion of the upper plate 41 and the lower plate 42 is set to be smaller than the thickness t of the workpiece W in the laminate direction.

In the mortar-shaped separation device 40, the workpiece W introduced through the introduction port 41A at the center of the upper plate is introduced into a center space formed between the upper plate 41 and the lower plate 42 (Fig. 6(a)). At the time of the introduction, an impact is applied to the workpiece W by the rotating upper plate 41 or lower plate 42, and the workpiece W can be further crushed. Then, the workpiece W moves outward in a radial direction R from the central space by centrifugal force (Fig. 6(b)). The workpiece W introduced to the separation device 40 may be temporarily inclined due to overlapping or the like. However, in the process of the above movement, the workpiece W is sandwiched between the upper plate 41 and the lower plate 42, is pulverized by the relative movement of the upper plate 41 and the lower plate 42 in the circumferential direction, and is discharged to the outside of the separation device 40 (Fig. 6(c)).

Note that the pulverization only needs to be performed to crush the substrate 21 to a size that is enough to pass through the separation device 40, and it is not necessary to crush the whole substrate 21 to a powdery state.

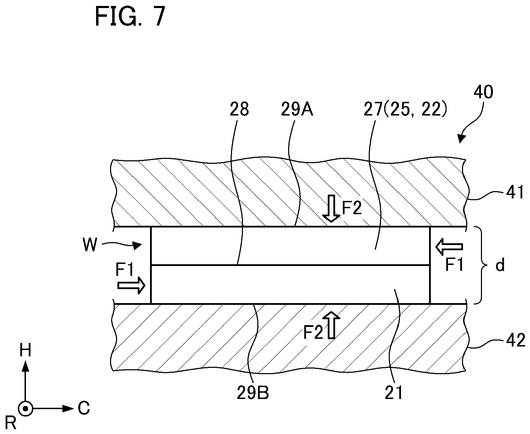

Here, with reference to Fig. 7, force acting on the workpiece W in the mortar-shaped separation device 40 will be described. The up-down direction in Fig. 7 is a height direction (H) parallel to a rotation axis Ax of the separation device 40, and the left-right direction in Fig. 7 is a circumferential direction (C) of the separation device 40. The direction perpendicular to the paper surface of Fig. 7 is a radial direction (R) of the separation device 40.

In addition, the workpiece W illustrated in Fig. 7 exemplarily illustrates a configuration in which the resin layer 27 is formed on the upper surface side of the substrate 21 for simplicity. The resin layer 27 in Fig. 7 includes, for example, the second sealing layer 25 and the back sheet 22. To be noted, although not illustrated in Fig. 7, the first sealing layer 24 may be formed on the lower surface side of the substrate 21 of the workpiece W.

By the relative movement of the upper plate 41 and the lower plate 42 in the circumferential direction C in the separation device 40, a shear load F1 is applied to the workpiece W from a direction (left-right direction in the drawing) intersecting the lamination direction of the substrate 21 and the resin layer 27.

Among the constituent materials of the workpiece W, the substrate 21 is less likely to be subjected to shear deformation than the resin layer 27. Therefore, in the workpiece W, shear stress based on the shear load F1 acts the most at an interface 28 where the substrate 21 that is relatively less likely to be subjected to shear deformation and the resin layer 27 that is relatively likely to be subjected to shear deformation are bonded together. Due to the concentration of the shear stress at the interface 28, the resin layer 27 is peeled off at the interface 28 with the substrate 21, and the resin layer 27 is separated from the substrate 21.

In addition, as illustrated in Fig. 6, the distance between upper plate 41 and lower plate 42 decreases toward the outer peripheral side due to the inclination of the tapered surface 41B of upper plate 41. Meanwhile, the workpiece W introduced into the separation device 40 moves outward in the radial direction R by centrifugal force. Therefore, as the workpiece W moves outward in the radial direction R, the workpiece W is sandwiched between the upper plate 41 and the lower plate 42, and a compressive load F2 in the lamination direction (up-down direction in the drawing) of the substrate 21 and the resin layer 27 is also applied to the workpiece W. To be noted, since the distance between the upper plate 41 and the lower plate 42 is smaller on the outer peripheral side of the separation device 40 than on the inner peripheral side of the separation device 40, the compressive load F2 increases as the workpiece W moves outward in the radial direction R.

Here, when the compressive load F2 is applied to the workpiece W in the lamination direction (up-down direction in the drawing), the resin layer 27 that is relatively easily deformed is crushed and compressed in the lamination direction. As a result, the cross-sectional area of the workpiece W on a plane along the lamination direction is smaller after compression than before compression. Therefore, when the shear load F1 is applied to the workpiece W in a state of being compressed in the lamination direction, the shear stress (shear load F1/cross-sectional area) increases by an amount by which the cross-sectional area of the workpiece W becomes smaller than before compression. For the above reason, when the compressive load F2 is applied to the workpiece W in the lamination direction, the resin layer 27 is more easily separated from the interface 28 with the substrate 21.

Further, in addition to the above-described shear load F1, the compressive load F2 that is stronger as the distance between the upper plate 41 and the lower plate 42 is narrower is applied to the workpiece W, and thus the substrate 21 is crushed by these loads. At this time, due to the difference in brittleness between the substrate 21 and the resin layer 27, there is a difference in ease of pulverization and the size of fragments after treatment.

Specifically, since the substrate 21 is more brittle than the resin layer 27, the substrate 21 is easily crushed into powder, and the resin layer 27 is less likely to be powder than the substrate 21. In addition, when the average sizes of the substrate 21 and the resin layer 27 after the processing are compared, the resin layer 27 is larger as fragments.

In addition, when the substrate 21 is pulverized and reduced in size, the bonding surface between the substrate 21 and the resin layer 27 is reduced. Then, the resin layer 27 is more easily separated from the substrate 21 by application of the shear load by the upper plate 41 and the lower plate 42.

Furthermore, due to the relative movement of the upper plate 41 and the lower plate 42, frictional force is applied to each of a contact surface 29A between the upper plate 41 and the workpiece W and a contact surface 29B between the lower plate 42 and the workpiece W. The contact surfaces 29A and 29B of the workpiece W are scraped by this frictional force, and thus the substrate 21 and the resin layer 27 can also be pulverized by this.

As described above, in the separation device 40, the separation of the resin layer 27 by the shear stress at the interface 28 between the substrate 21 and the resin layer 27 of the workpiece W and the pulverization of the substrate 21 are performed substantially simultaneously in parallel. As a result, a mixture of fragments of the resin layer 27 separated from the substrate 21 and the pulverized substrate 21 is discharged from the separation device 40.

Here, the shear load applied to the workpiece W in the separation device 40 can be changed by adjusting the parameters of the distance d between the upper plate 41 and the lower plate 42 and the relative movement amount (for example, the rotation speed) of the upper plate 41 and the lower plate 42. By adjusting these parameters, the peelability of the resin layer 27 and the size of the pulverized substrate 21 are controlled. To be noted, as described below, changes in these parameters produce different effects.

By adjusting the distance d between the upper plate 41 and the lower plate 42, the mechanical force applied to the workpiece W can be adjusted. Considering workpieces W of the same size, a stronger mechanical force can be applied by reducing the distance d. As a result, the smaller the distance d between the upper plate 41 and the lower plate 42, the smaller the average size of the processed substrate 21. The distance d between the upper plate 41 and the lower plate 42 is appropriately adjusted according to the size of the workpiece W and the lamination form of the workpiece W, and may be, for example, in the range of 100 µm to 3000 µm.

Further, a relative difference in the rotation speed between the upper plate 41 and the lower plate 42 may be, for example, in the range of 500 rpm to 3000 rpm. When the rotation speed described above is low, the shear load F1 applied to the workpiece W becomes small. When the rotation speed is high, the shear load F1 applied to the workpiece W increases, but a phenomenon in which frictional heat is generated and the workpiece W is melted may occur. In addition, the lower the rotation speed, the longer the time during which the shear load F1 is applied to the workpiece W.

In addition, in the upper plate 41 or the lower plate 42 of the separation device 40, irregularities such as grooves and protrusions may be formed on the contact surface with the workpiece W, and a mechanical force may be applied to the workpiece W by these irregularities.

In addition, the workpiece W may be continuously or intermittently introduced into the separation device 40. By continuously introducing the workpiece W, a mechanical force is applied to the workpiece W while the workpiece W moves from a center portion where the introduction port 41A is located toward the outer periphery.

At the time of the processing in the separation device 40, water may be added to perform a wet treatment. According to the wet treatment, the workpiece W and the separation device 40 can be cooled, and scattering of the pulverized product can be reduced. To be noted, in dry treatment in which water is not added, the following can also be performed. For example, the separation device 40 may be disposed in an unillustrated cavity, blades may be attached to the upper plate 41 or the lower plate 42 to generate an air flow, and the pulverized product in the cavity may be recovered by a cyclone effect. Alternatively, the pulverized product may be collected by a dust collector.

In addition, although a configuration in which one resin layer 27 is formed on the substrate 21 is exemplified as the workpiece W in Fig. 7, various configurations such as sealing layer/substrate/sealing layer/back sheet, sealing layer/substrate/sealing layer, substrate/sealing layer, and the like can be exemplified as the lamination form of the workpiece W as described above. The lamination form of the workpiece W is not limited to those described above, and may be a laminate structure in which the substrate 21 and the resin layer 27 are laminated.

In addition, substrate/sealing layer/substrate/sealing layer/back sheet in which the cover glass 23 is not separated can be processed as the workpiece W. Furthermore, as described in the description of step S2, the back sheet 22 may be separated in advance for the purpose of improving the use form of each material in the workpiece W and the purity after separation. The back sheet 22 can be separated by, for example, the separation device 30 used for separating the cover glass 23.

In addition, the workpiece W may be a laminate such as sealing layer/back sheet. For example, when the sealing material is ethylene-vinyl acetate copolymer (EVA) and the main material of the back sheet is polyethylene terephthalate (PET), the shear deformability of the sealing layer of the sealing material is higher than the shear deformability of the back sheet. Also in a combination of a sealing layer of another sealing material and a back sheet, the sealing layer of the sealing material is often higher in shear deformability than the back sheet.

### (Step S5: Etching of Electric Cell Layer)

Next, the pulverized product (mixture of fragments of the resin layer 27 separated from the substrate 21 and the pulverized substrate 21) of the workpiece W discharged from the mortar-shaped separation device 40 is immersed in a dissolving liquid such as nitric acid. As a result, the electric cell layer 21B of the pulverized substrate 21 is etched, and the electric cell layer 21B can be removed from the substrate 21.

The type of the dissolving liquid used in the etching may be appropriately selected according to the type of the compound thin film of the electric cell layer 21B. For example, in the case of a CIS-based thin film of a group I-III-VI₂ compound thin film or a CZTS-based thin film of a group I₂-II-IV-VI₄ compound thin film, nitric acid can be used as the dissolving liquid. In the case of a CdTe-based thin film of the group II-VI compound thin film, an acid such as hydrochloric acid or hydrobromic acid can be used as the dissolving liquid.

Fragments (for example, EVA) of the sealing layers 24 and 25 having a small specific gravity may float on the surface of the dissolving liquid or the solution at the time of water washing. The floating fragments of the sealing layers 24 and 25 can also be selectively separated as a first separated product by filtration or wet specific gravity separation. The first separated product includes a particulate product and a sheet-like product.

Note that, by immersing the pulverized product of the workpiece W in water before etching, fragments of the sealing layer having a small specific gravity can be selectively separated as the first separated product first.

### (Step S6: Solid-liquid Separation)

Next, the pulverized product of the workpiece W immersed in the dissolving liquid for etching is separated into a liquid and a solid by centrifugation. As a result, the dissolving liquid such as nitric acid is removed. The remaining solid portion includes a particulate portion and a sheet-like portion. At this stage, fragments of the resin layer 27 and the pulverized substrate 21 are in a mixed state.

### (Step S7: Selective Separation of Material)

Next, the solid portion obtained in step S6 is selectively separated into remaining fragments of the sealing layers 24 and 25 (first separated product), the substrate 21 (second separated product), and the back sheet 22 (third separated product) by wet specific gravity separation. The specific gravities of the sealing layers 24 and 25, the back sheet 22, and the substrate 21 (glass, silicon) increase in this order, and these can be selectively separated using the difference in specific gravity. In the wet specific gravity separation, it is preferable to use a jig-type specific gravity separation device or a table-type specific gravity separation device. To be noted, in the case of the workpiece W in which the back sheet 22 is separated in advance, the fragments of the substrate 21 and the sealing layers 24 and 25 are selectively separated in step S7.

In addition, it is also possible to separate the particulate second separated product and the sheet-like third separated product by a sieve instead of the wet specific gravity separation described above. As the mesh (mesh opening) of the sieve, for example, a sieve corresponding to JIS test sieves 4 (4.75 mm) to 10 (1.7 mm) can be used, and may be appropriately selected according to the sizes of the second separated product and the third separated product. The back sheet 22 mainly remains as the third separated product on the sieve, and the second separated product passes through the sieve. The second separated product mainly contains glass.

In addition, the selective separation by the sieve may be performed a plurality of times in order from a small mesh to a large mesh. In addition, the second separated product and the third separated product can be also separated by using a cyclone (powder separation device) instead of the sieve.

This is the end of the description of the recycling method of Fig. 3.

As described above, in the present embodiment, by using the mortar-shaped separation device 40, a shear load is applied to the workpiece W that is a laminate structure from the direction intersecting the lamination direction of the resin layer 27, and the substrate 21 of the workpiece W is pulverized (S4). As a result, the resin layer 27 is separated from the substrate 21 at the interface 28 between the substrate 21 and the resin layer 27.

When a shear load is applied to the workpiece W from a direction intersecting the lamination direction of the resin layer 27, a force is applied from a direction along the interface 28 between the substrate 21 and the resin layer 27, so that the resin layer 27 can be efficiently peeled off at the interface 28 between the substrate 21 and the resin layer 27.

Further, due to a difference in brittleness between the substrate 21 and the resin layer 27, the substrate 21 of the workpiece W is easily pulverized into small particles, but the resin layer 27 is difficult to pulverize. Therefore, by pulverizing the substrate 21, the separation efficiency of the substrate 21 and the resin layer 27 is further improved.

In addition, application of a shear load to the workpiece W and pulverization of the substrate 21 are performed substantially simultaneously in parallel in the mortar-shaped separation device 40. Therefore, the substrate 21 is reduced in size by pulverization of the substrate 21, and the contact surface between the substrate 21 and the resin layer 27 is reduced in the workpiece W, so that the substrate 21 and the resin layer 27 are more easily separated.

Furthermore, according to the present embodiment, for example, the recycling cost can be greatly reduced as compared with the case where the resin layer is separated from the substrate by thermal decomposition by firing.

### <Examples>

Hereinafter, examples and comparative examples concerning a method for recycling a solar cell module will be described.

### (Example 1)

In Example 1, a CIS-based thin-film solar cell was formed on a glass substrate, and a solar cell panel (cover glass substrate/layer of sealing material 1/glass substrate including an electric cell layer/layer of sealing material 2/back sheet) sealed with a cover glass and a back sheet was separated into a glass substrate and a resin layer (layer of sealing material, back sheet).

In Example 1, the cover glass substrate is made of white plate reinforced glass and has a thickness of about 3.2 mm. The layer of the sealing material 1 is made of EVA and has a thickness of about 300 µm. The glass substrate is made of high strain point glass and has a thickness of about 1.8 mm. The layer of the sealing material 2 is made of EVA and has a thickness of about 600 µm. The back sheet is a lamination film of PET and has a thickness of about 200 µm.

In Example 1, first, the cover glass substrate was removed in a panel separating step. Thereafter, the remaining portion after removing the cover glass substrate was crushed by a crusher in a preliminary crushing step to obtain a workpiece (layer of sealing material 1/glass substrate (including an electric cell layer)/layer of sealing material 2/back sheet) having a size of about 1 mm to 10 mm.

Next, the workpiece was introduced into a mortar-shaped separation device to separate the resin layer from the substrate. In the upper plate and the lower plate of the separation device, a groove was formed on a contact surface with the workpiece, and the groove was formed up to the outermost periphery of the upper plate and the lower plate. In Example 1, the distance between the upper plate and the lower plate of the separation device was set to 300 µm, and the relative rotation speed between the upper plate and the lower plate was set to 1500 rpm.

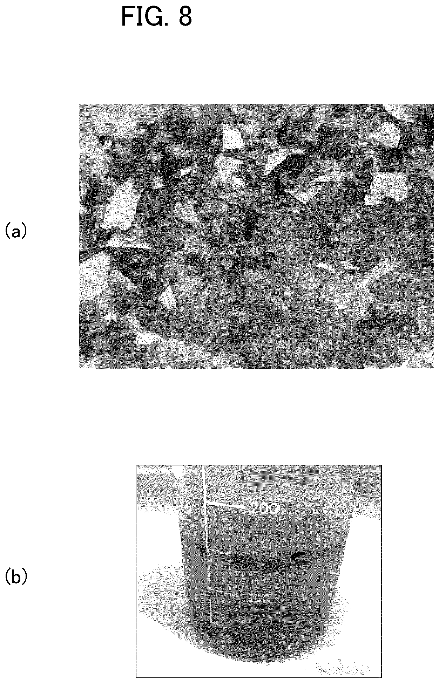

Fig. 8(a) illustrates a mixture of fragments of the resin layer and the pulverized substrate discharged from the separation device in Example 1.

Next, the mixture of the fragments of the resin layer and the pulverized substrate was immersed in a dissolving liquid containing nitric acid to etch the electric cell layer of the substrate. As illustrated in Fig. 8(b), the powdery substrate from which the electric cell layer had been removed and the back sheet were settled in the dissolving liquid, and the fragments of the sealing material 1 and the sealing material 2 floated in the dissolving liquid.

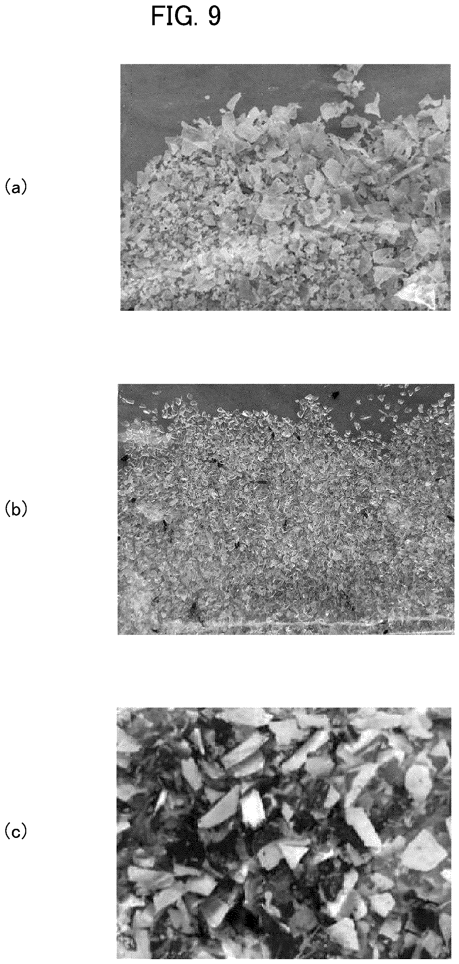

Fragments of the sealing material 1 and the sealing material 2 floating in the dissolving liquid were recovered by scooping with filter paper (first separated product). As illustrated in Fig. 9(a), the fragments of the sealing material 1 and the sealing material 2 included particulate fragments and sheet-like fragments.

Next, the fragments of the sealing material 1 and the sealing material 2 described above and the sediment in the dissolving liquid (mixture of the powdery substrate and the back sheet) were washed with water. Thereafter, the washed sediment in the dissolving liquid was centrifuged to separate a liquid portion and a solid portion.

Then, the solid portion of the sediment of the dissolving liquid was sieved to be separated into a particulate glass substrate (second separated product) and a sheet-like back sheet (third separated product). Fig. 9(b) illustrates the second separated product separated from the sediment in the dissolving liquid in Example 1, and Fig. 9(c) illustrates the third separated product separated from the sediment in the dissolving liquid in Example 1.

### (Example 2)

In Example 2, the resin layer was separated from the glass substrate of the workpiece by changing the distance between the upper plate and the lower plate when the workpiece was processed by the mortar-shaped separation device among the series of processing in Example 1, and the separability between the glass substrate and the resin layer was confirmed. In Example 2, the distance between the upper plate and the lower plate was set to 100 µm, 300 µm, 500 µm, and 1000 µm, respectively.

The separability was confirmed by the following method in Example 2.

First, about 10 g of the back sheet processed by the separation device was collected, and heated to 1000°C in an oxygen atmosphere to burn the back sheet and the sealing material. The weight (weight after firing) of glass as a residue after firing was measured, and the weight before firing and the weight after firing were compared to evaluate the residual ratio of glass contained in the third separated product mainly including the back sheet.

The results of Example 2 are illustrated in Table 1.

When the distance between the upper plate and the lower plate of the separation device was set to 100 µm and 300 µm, the residual ratio of glass was less than 1% by weight (Wt%), and the back sheet (resin) could be efficiently separated from the glass substrate.

### [Table 1]

**Table 1 Residual ratio of glass of third separated product after firing**

| Distance (µm) | 100 | 300 | 500 | 1000 |
|---|---|---|---|---|
| Weight before firing (g) | 10.365 | 10.002 | 10.018 | 11.012 |
| Weight after firing (g) | 0.078 | 0.063 | 0.612 | 2.397 |
| Residual ratio (Wt%) | 0.75 | 0.63 | 6.11 | 21.77 |

### (Example 3)

In Example 3, the particle size distribution of glass was evaluated for the particulate glass substrate (second separated product) obtained in Example 2.

Specifically, about 25 g of each of the second separated products obtained when the distance between the upper plate and the lower plate was set to 100 µm, 300 µm, 500 µm, and 1000 µm was collected, and the glass of each of the collected second separated product was sieved to be granulated for each particle size. As the mesh (mesh opening) of the sieve, sieves corresponding to JIS test sieves 10 (1.7 mm), 14 (1.18 mm), 18 (850 µm), 26 (600 µm), and 60 (250 µm) were used.

In the method for evaluating the particle size distribution of glass in Example 3, first, the weight of glass separated for each particle size was measured. Then, the ratio of the weight of glass included in each glass particle size range with respect to the weight of the entire glass was determined to obtain a particle size distribution of glass.

In addition, the median value of the glass particle size range was regarded as the glass particle size of the range, and the average particle size of the glass was calculated from the ratio of the weight in the glass particle size range.

The results of Example 3 are illustrated in Table 2.

When the distance between the upper plate and the lower plate was set to 100 µm, 300 µm, 500 µm, and 1000 µm, the average particle sizes of the glass were 745 µm, 838 µm, 955 µm, and 1080 µm, respectively. In addition, the smaller the distance between the upper plate and the lower plate was, the smaller the average particle size of the glass was. To be noted, the reason why the particle size of the glass is larger than the distance between the upper plate and the lower plate is that the processed workpiece is discharged through the grooves because the grooves formed on the contact surfaces of the upper plate and the lower plate with the workpiece are formed up to the outermost peripheries of the upper plate and the lower plate.

### [Table 2]

**Table 2 Particle size distribution of glass**

| | Distance (µm) | | | |
|---|---|---|---|---|
| Particle size of glass (µm) | 100 | 300 | 500 | 1000 |
| 0 to 250 | 9.20% | 5.37% | 3.95% | 1.81% |
| 250 to 600 | 26.4% | 23.9% | 13.0% | 5.42% |
| 600 to 850 | 23.0% | 19.5% | 15.8% | 13.9% |
| 850 to 1100 | 29.3% | 30.2% | 37.9% | 35.5% |
| 1100 to 1700 | 12.1% | 21.0% | 29.4% | 43.4% |

### (Example 4)

In Example 4, in the series of processing in Example 1, the processed workpiece discharged from the mortar-shaped separation device was immersed in a dissolving liquid containing nitric acid to etch the electric cell layer of the substrate, and then the liquid portion and the solid portion were separated by centrifugation. Then, the powdery substrate from which the electric cell layer had been removed, the sealing material, and the back sheet were selectively separated by a jig-type specific gravity separation device.

In Example 4, in a tank of the jig-type specific gravity separation device, the layer of the sealing material having a small specific gravity, the back sheet, and the substrate were separated in this order, and the sealing material, the back sheet, and the substrate could be separately acquired.

In addition, the organic residue (residue of resin) in the substrate after the separation was 1.25 Wt%.

### (Example 5)

In Example 5, in the series of processing in Example 1, the workpiece from which the back sheet was separated in advance was introduced into a mortar-shaped separation device to separate the resin layer from the substrate. Then, the processed workpiece discharged from the mortar-shaped separation device was immersed in a dissolving liquid containing nitric acid to etch the electric cell layer of the substrate, and then the liquid portion and the solid portion were separated by centrifugation. Then, the powdery substrate from which the electric cell layer had been removed, and the sealing material were selectively separated by a jig-type specific gravity separation device similarly to Example 4.

In Example 5, in a tank of the jig-type specific gravity separation device, the layer of the sealing material having a small specific gravity and the substrate were separated in this order, and the sealing material and the substrate could be separately acquired.

Since the sealing material and the back sheet have relatively close specific gravities, the degree of difficulty in specific gravity separation is high. In Example 5, by removing the back sheet in advance, the separation accuracy of the material of the workpiece could be improved as compared with Example 4. As a result, the organic residue (resin residue) in the substrate after the separation was 0.17 Wt%.

### (Example 6)

In Example 6, a solar cell panel in which a crystalline silicon substrate was sealed with a cover glass and a back sheet (cover glass substrate/layer of sealing material 1/crystalline silicon substrate/layer of sealing material 2/back sheet) was separated into a glass substrate, a crystalline silicon substrate, and a resin layer (layer of sealing material, back sheet).

In Example 6, the cover glass substrate is made of white plate reinforced glass and has a thickness of about 3.0 mm. The thickness of the crystalline silicon substrate is about 180 µm. The layer of the sealing material 1 is made of EVA and has a thickness of about 450 µm. The layer of the sealing material 2 is made of EVA and has a thickness of about 650 µm. The back sheet is PET and has a thickness of about 60 µm.

In Example 6, first, the cover glass substrate was removed in a panel separating step. Thereafter, the remaining portion after removing the cover glass substrate was crushed by a crusher in a preliminary crushing step to obtain a workpiece (layer of sealing material 1/crystalline silicon substrate/layer of sealing material 2) having a size of about 1 mm to 10 mm.

Next, the workpiece was introduced into a mortar-shaped separation device to separate the resin layer from the crystalline silicon substrate. In Example 6, the distance between the upper plate and the lower plate of the separation device was set to 600 µm, and the relative rotation speed between the upper plate and the lower plate was set to 1500 rpm. The workpiece processed by the mortar-shaped separation device became a mixture of a sheet-like resin layer, a particulate resin layer, and a powdery crystalline silicon substrate.

Then, in Example 6, the separability between the silicon substrate and the resin layer (layer of sealing material, back sheet) was confirmed by the following method.

First, about 1000 g of a mixture of a resin layer and a silicon substrate obtained by processing by a mortar-shaped separation device was collected, and the collected mixture was sieved and separated. At this time, the sieving was performed using sieves having a larger mesh size to a smaller mesh size in this order, and the weight ratios of those obtained by respective sieves and those having passed through a mesh opening of 250 µm to the mixture subjected to sieving were calculated. The mesh (mesh opening) of the sieve used in Example 6 was the same as the conditions of Example 3 described above.

Next, about 1 g of the mixture separated by each sieve was collected and heated to 1000°C in an oxygen atmosphere to burn the resin of the back sheet and the sealing material. The weight (weight after firing) of silicon as a residue after firing was measured, and the weight before firing and the weight after firing were compared to evaluate the residual ratio of silicon contained in the mixture of the resin layer and the silicon substrate.

In Example 6, the weight ratio of those obtained by each sieve or having passed through the sieves and the residual ratio of silicon after firing are illustrated in Table 3.

### [Table 3]

**Table 3**

| Mesh size of sieve (µm) | Weight ratio (%) | Residual ratio (Wt%) |
|---|---|---|
| 1700 | 63.6 | 1.1 |
| 1100 | 6.2 | 0.9 |
| 850 | 2.3 | 0.7 |
| 600 | 1.5 | 0.7 |
| 250 | 0.8 | 1.2 |
| - (Passed through 250) | 25.6 | 97.6 |

As illustrated in Table 3, in Example 6, the residual ratio of silicon in those did not pass through each sieve having a mesh size of 250 µm or more was 1.1 Wt% when calculated in consideration of the weight ratio of those that did not pass through each sieve. Therefore, in Example 6, the resin (sealing material, back sheet) could be efficiently separated from silicon. In addition, about 98 Wt% of those that passed through a sieve with a mesh size of 250 µm was silicon.

In other words, by using a sieve having a mesh size of 250 µm, it is possible to distinguish between those containing about 98 Wt% of silicon and those containing about 99 Wt% of resin.

Here, as descried in Example 3 described above, depending on the distance between the upper plate and the lower plate, the ratio at which the particle size of the glass substrate processed by the separation device is 250 µm or more is 90% or more. For example, a case will be considered in which crushing is performed in the preliminary crushing step without removing the cover glass from the solar cell panel and processing is performed by a mortar-shaped separation device. In the above case, when the workpiece (mixture of glass substrate, resin layer, and silicon substrate) processed by the separation device is sorted using a sieve with a mesh size of 250 µm, those that do not pass through the sieve with a mesh size of 250 µm are a mixture of resin and glass containing almost no silicon. The mixture that does not pass through the sieve of 250 µm can be selectively separated by a jig type gravity separation device, so that the sealing material, the back sheet, and the glass substrate can be obtained separately. In contrast, those that have passed through the sieve of 250 µm are a mixture of glass and silicon containing almost no resin. As described above, the substrate and the resin can be separated.

### (Example 7)

In Example 7, a solar cell panel (cover glass substrate/layer of sealing material 1/crystalline silicon substrate/layer of sealing material 2/back sheet) similar to that in Example 6 is targeted. In Example 7, the cover glass substrate and the back sheet were removed in the panel separating step. Subsequent steps are the same as in Example 6.

In Example 7, the workpiece processed by the mortar-shaped separation device became a mixture of a sheet-like sealing material layer, a particulate sealing material layer, and a powdery crystalline silicon substrate. Then, the mixture described above was separated into a crystalline silicon substrate and a sealing material by sieving.

In Example 7, the weight ratio of those obtained by each sieve or having passed through the sieves and the residual ratio of silicon after firing are illustrated in Table 4.

### [Table 4]

**Table 4**

| Mesh size of sieve (µm) | Weight ratio (%) | Residual ratio (Wt%) |
|---|---|---|
| 1700 | 43.5 | 0.4 |
| 1100 | 8.3 | 0.8 |
| 850 | 2.2 | 0.2 |
| 600 | 1.1 | 4.1 |
| 250 | 0.8 | 1.1 |
| - (Passed through 250) | 44.1 | 99.0 |

As illustrated in Table 4, in Example 7, the residual ratio of silicon in those did not pass through each sieve having a mesh size of 250 µm or more was 0.5 Wt% when calculated in consideration of the weight ratio of those that did not pass through each sieve. Therefore, in Example 7, the resin (sealing material) could be efficiently separated from silicon. In addition, 99 Wt% of those that passed through a sieve with a mesh size of 250 µm was silicon.

In other words, by using a sieve having a mesh size of 250 µm, it is possible to distinguish between those containing 99 Wt% of silicon and those containing 99.5 Wt% of resin.

### (Comparative Example 1)

In Comparative Example 1, each material was separated from a workpiece having the same configuration as in Example 1 by a jet mill that performs separation using collision between particles. That is, in Comparative Example 1, no shear load is applied to the workpiece in a direction intersecting the lamination direction, and the substrate is not mechanically pulverized.

In Comparative Example 1, impact between particles was applied by changing the air flow in the range of 0.5 m³/min to 10 m³/min, but the substrate portion of the processed workpiece was not crushed in any of these. In addition, as a result of immersing the processed workpiece in water, most of the workpiece was settled integrally, and separation of each material was not observed.

### (Comparative Example 2)

In Comparative Example 2, for a workpiece having the same configuration as in Example 1, each material was separated by a high-speed hammer-type mill that performs separation by applying an impact to the workpiece with a high-speed rotating hammer. That is, in Comparative Example 2, the workpiece is pulverized by a mechanical impact, but a shear load is not applied to the workpiece in a direction intersecting the lamination direction.

In Comparative Example 2, as a result of applying impact with a hammer while changing the rotation speed in the range of 5000 rpm to 15000 rpm, the substrate portion in the obtained processed product was micronized. However, as a result of immersing the processed product in water, most of the processed product was settled integrally, and separation of each material was not observed.

### <Supplementary Matters of Embodiment>

In the above embodiment, a case of separating a resin layer from a substrate of a solar cell panel has been described as an example of the method for separating a laminate structure. However, the method for separating a laminate structure of the present invention is not limited to the case of being applied to a solar cell panel, and can be widely applied as long as it is a laminate structure in which a resin layer is formed on a substrate.

For example, the present invention can also be applied to recycling laminated glass obtained by bonding a plurality of glasses with an adhesive resin, a display panel, and the like. For example, in the case of laminated glass, glass corresponds to a substrate, and a layer (adhesive layer) of an adhesive for bonding glass corresponds to a resin layer.

In addition, the type of the resin layer of the laminate structure is not limited to the sealing layer and the adhesive layer, and for example, the present invention may be applied to a laminate structure in which a resin layer such as a paint layer or a coating layer is formed on a substrate.

In addition, in the above embodiment, the description has been made on the assumption that the shape of the laminate structure is a flat plate shape. However, the laminate structure of the present invention can also be applied to a curved laminate structure such as a curved screen display panel or a laminated glass used for a windshield or a rear glass of a vehicle.

The workpiece becomes relatively close to a flat plate shape by preliminarily crushing the curved laminate structure. Further, since the workpiece is pulverized in the mortar-shaped separation device, the workpiece approaches the state of the case where the flat plate-shaped laminate structure is processed. Therefore, it can be seen that the present invention can be applied to the case of processing a curved laminate structure similarly to the case of processing a flat plate-shaped laminate structure.

As described above, the embodiment of the present invention has been described, but the embodiment is presented as an example, and is not intended to limit the scope of the present invention. The embodiment can be implemented in various forms other than the above, and various omissions, substitutions, modifications, and the like can be made without departing from the gist of the present invention. Embodiments and modifications thereof are included in the scope and gist of the present invention, and the invention described in the claims and equivalents thereof are also included in the scope and gist of the present invention.

In addition, the present application claims priority based on Japanese Patent Application No. 2019-201487 filed on November 6, 2019, and the entire contents of Japanese Patent Application No. 2019-201487 are incorporated herein by reference.

### Reference Signs List

- 10, 10A: solar cell module
- 11, 11A: solar cell panel
- 21: electric cell portion (substrate)
- 22: back sheet
- 23: cover glass
- 24, 25, 26: sealing layer
- 27: resin layer
- 28: interface
- 40: separation device
- W: workpiece

## Claims

1. A method for separating a laminate structure in which a resin layer is formed on a substrate, the method comprising:
applying a shear load to the laminate structure from a direction intersecting a lamination direction of the resin layer; and
pulverizing the substrate,
wherein the resin layer is separated from the substrate at an interface between the substrate and the resin layer.

2. The method for separating a laminate structure according to claim 1, wherein
the applying the shear load and the pulverizing the substrate are performed in parallel.

3. The method for separating a laminate structure according to claim 1 or 2, wherein
the resin layer includes a layer formed from a sealing material.

4. The method for separating a laminate structure according to claim 3, the method further comprising
first selective separating that selectively separate sealing layer by specific gravity separation by immersion in a solution after separating the resin layer from the substrate.

5. The method for separating a laminate structure according to claim 4, wherein
an electric cell layer is formed in the substrate,
the solution is a dissolving liquid containing acid, and
in the first selective separating, the electric cell layer of the substrate is etched by the dissolving liquid.

6. The method for separating a laminate structure according to claim 4 or 5, wherein
the resin layer further includes a layer of a sheet member formed from a material different from the sealing material, and
the method further comprises a second selective separating that selectively separate a pulverized product of the substrate and the sheet member from a residue of the first selective separating.

7. The method for separating a laminate structure according to any one of claims 1 to 6, wherein
the laminate structure is a solar cell panel.
